# EUROPÄISCHE PATENTSCHRIFT

(11) **EP 4 026 166 B1**
(45) Veröffentlichungstag und Bekanntmachung des Hinweises auf die Patenterteilung: **11.12.2024**
(21) Anmeldenummer: 20789486.6
(22) Anmeldetag: 29.09.2020
(51) Int. Cl.: H01L 23/427

(54) **ELEKTRONIKMODUL MIT EINER PULSIERENDEN HEATPIPE**
ELECTRONIC MODULE WITH PULSATING HEATPIPE
MODULE ÉLECTRONIQUE COMPRENANT UN CALODUC PULSATIF

(30) Priorität: 18.11.2019 EP 19209734
(43) Veröffentlichungstag der Anmeldung: 13.07.2022
(73) Patentinhaber: Siemens Aktiengesellschaft, 80333 München (DE)
(72) Erfinder: SCHWARZ, Florian, 90766 Fürth (DE); HENSLER, Alexander, 91466 Gerhardshofen (DE); SCHIERLING, Hubert, 91052 Erlangen (DE)
(74) Vertreter: Siemens Patent Attorneys
(86) Internationale Anmeldenummer: PCT/EP2020/077194
(87) Internationale Veröffentlichungsnummer: WO 2021/099019

(56) Entgegenhaltungen:
- EP-A1- 3 336 471
- US-A- 5 268 812

## Beschreibung

Die Erfindung betrifft ein Elektronikmodul, das eine pulsierende Heatpipe aufweist.

Mit der fortschreitenden Miniaturisierung in der Mikroelektronik nimmt die Leistungsdichte von Elektronikmodulen und damit auch die Wärmestromdichte von den Elektronikmodulen erzeugter Wärme zu. Leistungsstarke elektrische Bauelemente wie Leistungshalbleiter erzeugen bereits heute thermische Verluste mit Wärmestromdichten von mehr als 100 W/cm², mit steigender Tendenz. Um Elektronikausfälle durch thermische Überlastungen zu vermeiden, werden daher immer effektivere Konzepte zum Entwärmen der elektrischen Bauelemente benötigt.

US 2018/0158756 A1 offenbart eine integrierte Schaltungsvorrichtung mit mindestens einer auf einem Substrat angeordneten Halbleitervorrichtung, wobei das Substrat eine in ihm ausgebildete pulsierende Heatpipe aufweist.

Eine pulsierende Heatpipe (engl. pulsating heat pipe, PHP), die auch als oszillierende Heatpipe (engl. oscillating heat pipe, OHP) bezeichnet wird, ist eine Vorrichtung zur Wärmeübertragung mit einer geschlossenen Kanalstruktur, in der ein Wärmetransportmedium angeordnet ist, das entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an.

Stand der Technik wird in den Dokumenten EP3336471 A1 und US5268812 A beschrieben.

Der Erfindung liegt die Aufgabe zugrunde, ein verbessertes Elektronikmodul mit einer pulsierenden Heatpipe anzugeben.

Die Aufgabe wird erfindungsgemäß durch ein Elektronikmodul mit den Merkmalen des Anspruchs 1 und ein Verfahren zur Herstellung eines derartigen Elektronikmoduls mit den Merkmalen des Anspruchs 14 gelöst.

Vorteilhafte Ausgestaltungen der Erfindung sind Gegenstand der Unteransprüche.

Ein erfindungsgemäßes Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Eine pulsierende Heatpipe weist eine wesentlich höhere effektive Wärmeleitfähigkeit auf als beispielsweise ein vergleichbar großer massiver Wärmeleitkörper. Ferner funktioniert eine pulsierende Heatpipe lageunabhängig und rein passiv, so dass sie keine beweglichen Bauteile wie Pumpen und keine Stromversorgung erfordert. Dadurch weist eine pulsierende Heatpipe eine hohe Betriebssicherheit und Zuverlässigkeit auf. Des Weiteren kann eine pulsierende Heatpipe sehr flach und kompakt ausgeführt werden, beispielsweise mit einer Dicke von höchstens 3 mm. Durch diese Eigenschaften eignet sich eine pulsierende Heatpipe insbesondere zur Wärmeableitung von elektrischen Bauelementen mit einer hohen Leistungsdichte wie Leistungshalbleitern. Bei einem erfindungsgemäßen Elektronikmodul steht das Wärmetransportmedium einer pulsierenden Heatpipe in direktem Kontakt mit wenigstens einem elektrischen Bauelement und/oder mit einem elektrisch leitfähigen Kontaktelement, das mit wenigstens einem elektrischen Bauelement verbunden ist. Dadurch wird der thermische Kontakt des Wärmetransportmediums mit dem elektrischen Bauelement verbessert und die Wärmeableitung von dem elektrischen Bauelement durch die pulsierende Heatpipe erhöht.

Bei einer Ausgestaltung der Erfindung ist die pulsierende Heatpipe plattenartig ausgebildet. Bei einer weiteren Ausgestaltung der Erfindung weist die Kanalstruktur wenigstens einen mäanderartig verlaufenden Kanal auf. Bei einer weiteren Ausgestaltung der Erfindung ist die Kanalstruktur planar ausgebildet. Diese Ausgestaltungen der Erfindung ermöglichen eine hohe Wärmespreizwirkung der pulsierenden Heatpipe durch eine großflächige Gestaltung der pulsierenden Heatpipe beziehungsweise deren Kanalstruktur.

Bei einer weiteren Ausgestaltung der Erfindung weist die pulsierende Heatpipe wenigstens einen Keramikkörper auf, der Wände der Kanalstruktur bildet, die Kanalabschnitte der Kanalstruktur voneinander trennen. Die Bildung der Kanalstruktur durch wenigstens einen Keramikkörper ermöglicht vorteilhaft eine elektrisch isolierende Ausführung des Grundkörpers der pulsierenden Heatpipe mit guten thermischen Eigenschaften hinsichtlich der Wärmeleitfähigkeit und thermischen Beständigkeit des Grundkörpers.

Bei einer weiteren Ausgestaltung der Erfindung weist die pulsierende Heatpipe ein mit dem Wärmetransportmedium in Kontakt stehendes elektrisch leitfähiges Deckelelement auf, an dem wenigstens ein elektrisches Bauelement angeordnet ist und das die Kanalstruktur zumindest in einer Umgebung des elektrischen Bauelements deckelartig verschließt. Durch das Deckelelement kann dabei gleichzeitig eine hohe Wärmespreizung und Wärmeübertragung zum Wärmetransportmedium der pulsierenden Heatpipe zum Entwärmen eines an dem Deckelelement angeordneten elektrischen Bauelements und eine elektrische Kontaktierung des elektrischen Bauelements realisiert werden. Die pulsierende Heatpipe mit dem Deckelelement kann insbesondere eine so genannte DCB-Struktur (DCB = direct copper bonded) für wenigstens ein elektrisches Bauelement bilden, bei der der Grundkörper der pulsierenden Heatpipe als Substrat und ein aus Kupfer gefertigtes Deckelelement als elektrisch leitfähige Struktur fungieren.

Bei einer weiteren Ausgestaltung der Erfindung weist das Deckelelement im Bereich wenigstens eines an ihr angeordneten elektrischen Bauelements wenigstens eine Aussparung auf, durch die die Kanalstruktur der pulsierenden Heatpipe mit einer Oberfläche des elektrischen Bauelements verbunden ist, so dass das Wärmetransportmedium direkt mit der Oberfläche des elektrischen Bauelements in Kontakt steht. Eine derartige Aussparung in dem Deckelelement erhöht vorteilhaft die Wärmeübertragung von einem elektrischen Bauelement zu dem Wärmetransportmedium durch den direkten Kontakt des Wärmetransportmediums mit dem elektrischen Bauelement.

Bei der Ausgestaltung der Erfindung ist das Deckelelement aus einem Metall, insbesondere aus Kupfer, oder einer Legierung gefertigt. Dadurch können vorteilhaft gleichzeitig eine gute thermische und eine gute elektrische Leitfähigkeit des Deckelelements realisiert werden.

Bei einer weiteren Ausgestaltung der Erfindung weist die pulsierende Heatpipe ein Trägerelement auf, das die Kanalstruktur auf einer dem Deckelelement gegenüberliegenden Seite verschließt. Insbesondere kann das Trägerelement aus demselben Material wie das Deckelelement gefertigt sein. Dadurch kann beispielsweise vorteilhaft ein Verbiegen der pulsierenden Heatpipe durch unterschiedliche thermische Ausdehnungskoeffizienten des Deckelelements und des Grundkörpers der pulsierenden Heatpipe verhindert oder reduziert werden.

Bei einer weiteren Ausgestaltung der Erfindung ist wenigstens ein elektrisches Bauelement in der Kanalstruktur der pulsierenden Heatpipe angeordnet, so dass es von dem Wärmetransportmedium umströmt wird. Diese Ausgestaltung der Erfindung ermöglicht eine besonders effiziente Entwärmung eines elektrischen Bauelements durch einen großflächigen Kontakt des elektrischen Bauelements mit dem Wärmetransportmedium.

Bei einer weiteren nicht beanspruchten Ausgestaltung des Elektronikmoduls weist die pulsierende Heatpipe eine Leiterplatte auf, die wenigstens einen Bereich der Kanalstruktur deckelartig verschließt und wenigstens eine Leiterbahn aufweist, die mit einem in der Kanalstruktur angeordneten elektrischen Bauelement elektrisch verbunden ist. Eine derartige Leiterplatte ermöglicht vorteilhaft die elektrische Kontaktierung eines in der Kanalstruktur angeordneten elektrischen Bauelements.

Bei einer weiteren Ausgestaltung der Erfindung ist das Wärmetransportmedium ein elektrisch nichtleitendes Fluid, insbesondere Perfluor-N-alkyl-morpholin. Die Ausführung der pulsierenden Heatpipe mit einem elektrisch nichtleitenden Wärmetransportmedium verhindert elektrische Verbindungen von elektrischen Bauelementen untereinander oder mit anderen elektrischen Komponenten durch das Wärmetransportmedium. Perfluor-N-alkyl-morpholin eignet sich aufgrund seiner hohen Wärmeleitfähigkeit, seines Siedepunkts und seiner dielektrischen Eigenschaften als Wärmetransportmedium eines erfindungsgemäßen Elektronikmoduls. Ein elektrisch leitendes Fluid, beispielsweise Wasser, Aceton oder Methanol, kann nur dann als Wärmetransportmedium verwendet werden, wenn elektrische Bauelemente durch das Wärmetransportmedium nicht elektrisch miteinander verbunden werden, beispielsweise also, wenn für jedes elektrische Bauelement ein separater Kanal der Kanalstruktur vorgesehen ist, der nicht mit den Kanälen anderer elektrischer Bauelemente verbunden ist.

Bei einer weiteren Ausgestaltung der Erfindung ist wenigstens ein elektrisches Bauelement ein Leistungshalbleiter. Diese Ausgestaltung der Erfindung berücksichtigt, dass Leistungshalbleiter besonders hohe Leistungsdichten aufweisen und daher eine besonders gute Entwärmung erfordern.

Bei dem erfindungsgemäßen Verfahren zur Herstellung eines erfindungsgemäßen Elektronikmoduls wird die pulsierende Heatpipe nach dem Montieren aller elektrischen Bauelemente durch wenigstens eine Befüllungsöffnung mit dem Wärmetransportmedium befüllt und jede Befüllungsöffnung wird nach dem Befüllen verschlossen. Das Verfahren berücksichtigt, dass die pulsierende Heatpipe den hohen Prozesstemperaturen beim Montieren elektrischer Bauelemente möglicherweise nicht standhält und deshalb vorteilhaft erst nach dem Montieren aller elektrischen Bauelemente befüllt wird. Wenn die pulsierende Heatpipe ein elektrisch leitfähiges Deckelelement aufweist, ist jede Befüllungsöffnung vorzugsweise in dem Deckelelement ausgebildet und wird nach dem Befüllen, beispielsweise durch Löten oder Laserschweißen, verschlossen. Diese Ausgestaltung des Verfahrens berücksichtigt, dass eine Befüllungsöffnung in dem Deckelelement einfacher hermetisch verschlossen werden kann als beispielsweise eine Befüllungsöffnung in einem Keramikkörper, bei dem ein hermetisches Verschließen bei moderaten Temperaturen, die den Keramikkörper nicht schädigen, eine Herausforderung darstellt.

Bei einer weiteren Ausgestaltung des erfindungsgemäßen Verfahrens wird die pulsierende Heatpipe wenigstens teilweise durch 3D-Druck hergestellt. Im Fall, dass die pulsierende Heatpipe wenigstens einen Keramikkörper aufweist, wird beispielsweise jeder Keramikkörper durch 3D-Druck hergestellt. Wenn die pulsierende Heatpipe ein Deckelelement aufweist, kann (alternativ oder zusätzlich) ferner das Deckelelement durch 3D-Druck hergestellt werden. Diese Ausgestaltung des Verfahrens ermöglicht insbesondere die Herstellung geometrisch komplexer Kanalstrukturen, die durch konventionelle Herstellungsverfahren nicht oder nur mit erheblichem Aufwand herstellbar sind.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein erstes Ausführungsbeispiel eines Elektronikmoduls in einer ersten Schnittdarstellung,
- FIG 2: das in Figur 1 gezeigte Elektronikmodul in einer zweiten Schnittdarstellung,
- FIG 3: ein zweites Ausführungsbeispiel eines Elektronikmoduls in einer Schnittdarstellung,
- FIG 4: ein drittes Ausführungsbeispiel eines Elektronikmoduls in einer Schnittdarstellung.

Einander entsprechende Teile sind in den Figuren mit denselben Bezugszeichen versehen.

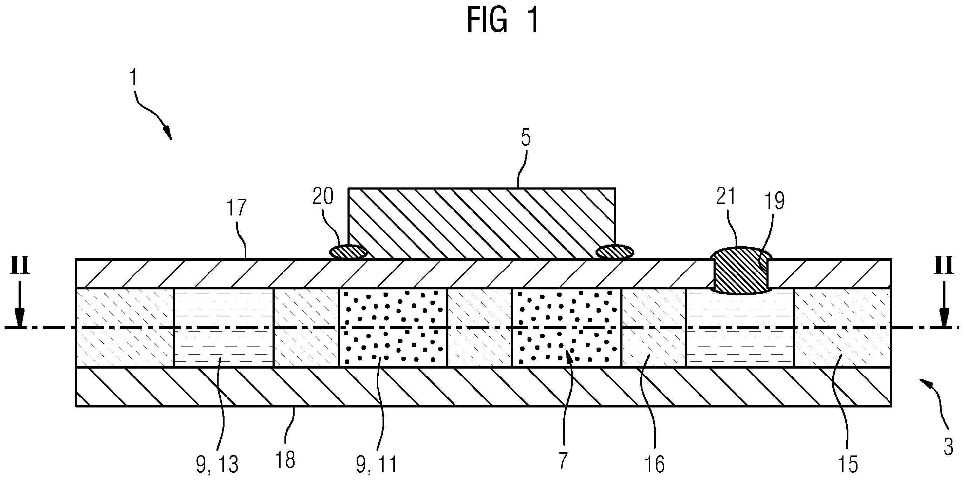

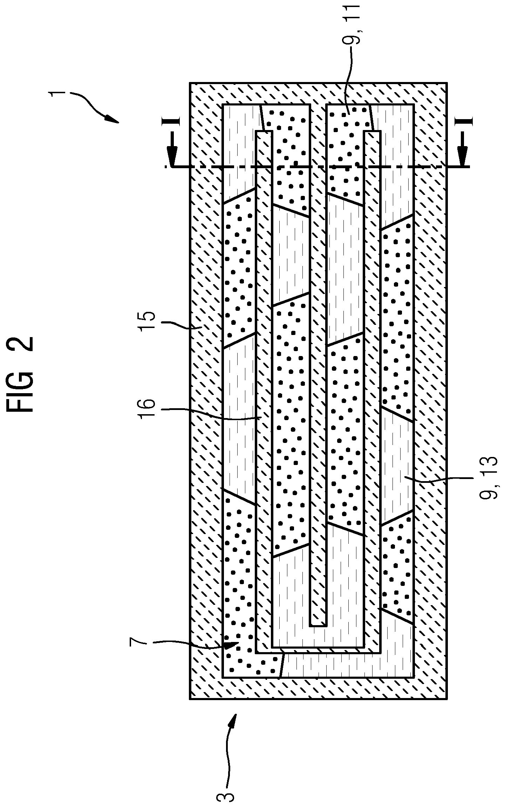

Figur 1 (FIG 1) und Figur 2 (FIG 2) zeigen ein erstes Ausführungsbeispiel eines erfindungsgemäßen Elektronikmoduls 1 in zwei Schnittdarstellungen mit zueinander orthogonalen Schnittebenen. Das Elektronikmodul 1 umfasst eine pulsierende Heatpipe 3 und ein elektrisches Bauelement 5.

Die pulsierende Heatpipe 3 weist eine planare Kanalstruktur 7 auf, in der ein Wärmetransportmedium 9 angeordnet ist. Die Kanalstruktur 7 ist als ein mäanderartig verlaufender, geschlossener Kanal ausgebildet. Das Wärmetransportmedium 9 bildet entlang des Kanals abwechselnd Dampfsegmente 11, in denen das Wärmetransportmedium 9 in einer gasförmigen Phase vorliegt, und Flüssigsegmente 13, in denen das Wärmetransportmedium 9 in einer gasförmigen Phase vorliegt. Die Dampfsegmente 11 und Flüssigsegmente 13 werden in dem Kanal durch Temperaturgradienten zu pulsierenden beziehungsweise oszillierenden Bewegungen angeregt. Beispielsweise ist das Wärmetransportmedium 9 Perfluor-N-alkyl-morpholin.

Die Kanalstruktur 7 wird von zwei Keramikkörpern 15, 16, einem elektrisch leitfähigen Deckelelement 17 und einem Trägerelement 18 gebildet. Die Keramikkörper 15, 16 bilden Wände der Kanalstruktur 7, die die Kanalabschnitte des Kanals voneinander trennen. Der Kanal weist beispielsweise einen Querschnitt mit einem Durchmesser von höchstens 1 mm auf. Die Wände zwischen benachbarten, parallel zueinander verlaufenden Kanalabschnitten weisen beispielsweise eine Dicke von höchstens 0,1 mm auf. Ferner bildet ein Keramikkörper 15 einen äußeren Rahmen der Kanalstruktur 7. Das Deckelelement 17 verschließt die Kanalstruktur 7 deckelartig auf einer Seite der pulsierenden Heatpipe 3. Das Deckelelement 17 ist beispielsweise aus Kupfer gefertigt und als eine Kupferschicht, Kupferplatte oder Kupferfolie ausgebildet. Das Trägerelement 18 verschließt die Kanalstruktur 7 auf einer dem Deckelelement 17 gegenüberliegenden Seite der pulsierenden Heatpipe 3. Auch das Trägerelement 18 ist beispielsweise aus Kupfer gefertigt und als eine Kupferschicht, Kupferplatte oder Kupferfolie ausgebildet.

Das elektrische Bauelement 5 ist beispielsweise ein Leistungshalbleiter, z. B. ein MOSFET oder ein IGBT. Das elektrische Bauelement 5 ist an dem Deckelelement 17 angeordnet und mit dem Deckelelement 17 elektrisch leitend und durch eine Lotverbindung 20 stoffschlüssig verbunden. Das Deckelelement 17 steht unterhalb des elektrischen Bauelements 5 in direktem Kontakt mit dem Wärmetransportmedium 9 und ermöglicht dadurch eine gute Wärmeleitung von dem elektrischen Bauelement 5 zu dem Wärmetransportmedium 9. Das Wärmetransportmedium 9 nimmt von dem elektrischen Bauelement 5 erzeugte Wärme auf, insbesondere in Form von latenter Wärme durch Verdampfen flüssigen Wärmetransportmediums 9, und leitet die Wärme zu einer Wärmesenke an einen anderen Ort der Kanalstruktur 7, wo das Wärmetransportmedium 9 Wärme, insbesondere in Form von latenter Wärme durch Kondensieren gasförmigen Wärmetransportmediums 9, abgibt.

Das Deckelelement 17 weist eine Befüllungsöffnung 19 auf, durch die die Kanalstruktur 7 mit dem Wärmetransportmedium 9 befüllt wird. Die Befüllungsöffnung 19 wird nach dem Befüllen der Kanalstruktur 7 mit einem Füllmaterial 21 verschlossen, beispielsweise durch Löten oder Laserschweißen.

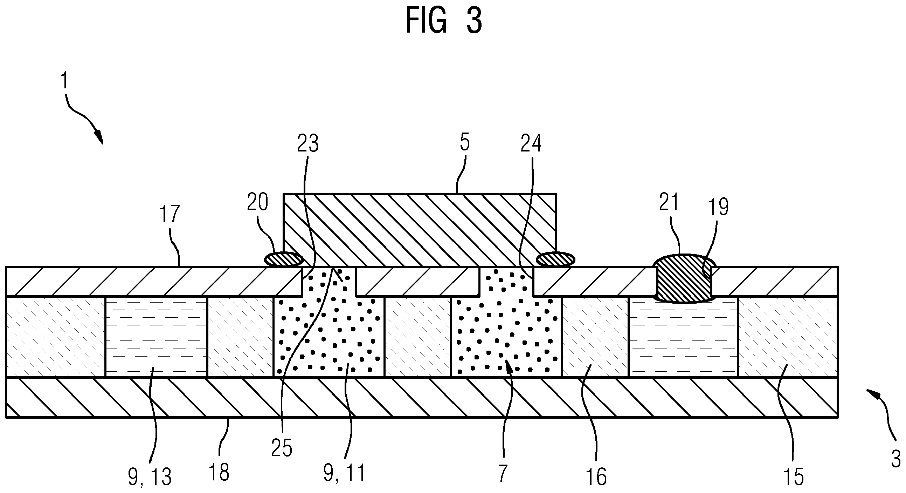

Figur 3 (FIG 3) zeigt ein zweites Ausführungsbeispiel eines erfindungsgemäßen Elektronikmoduls 1 in einer zu Figur 1 analogen Schnittdarstellung. Dieses Ausführungsbeispiel unterscheidet sich von dem in den Figuren 1 und 2 dargestellten Ausführungsbeispiel lediglich dadurch, dass das Deckelelement 17 im Bereich des elektrischen Bauelements 5 zwei Aussparungen 23, 24 aufweist, durch die die Kanalstruktur 7 mit einer Oberfläche 25 des elektrischen Bauelements 5 verbunden ist, so dass das Wärmetransportmedium 9 direkt mit der Oberfläche 25 in Kontakt steht.

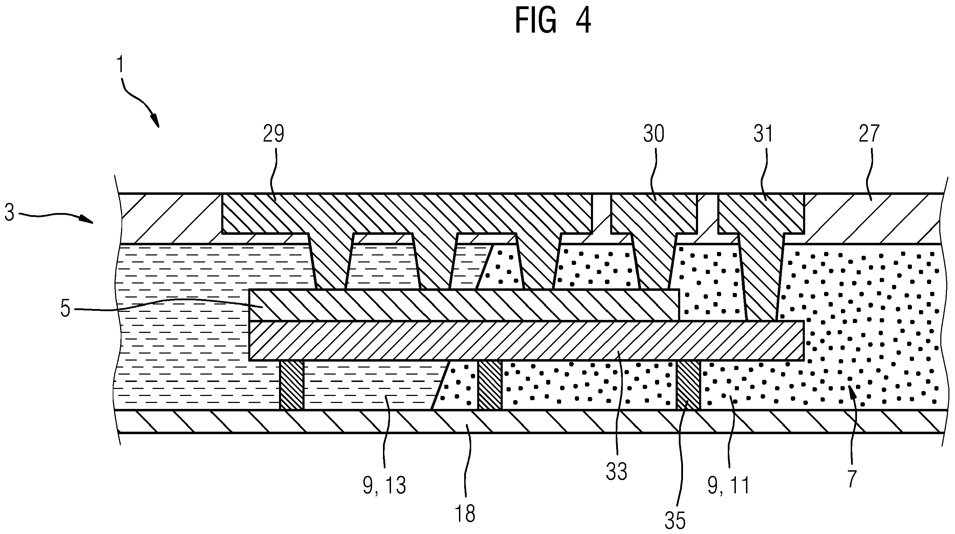

Figur 4 (FIG 4) zeigt ein drittes Ausführungsbeispiel eines nicht beanspruchten Elektronikmoduls 1 im Bereich eines elektrischen Bauelements 5 in einer zu Figur 1 analogen Schnittdarstellung. Das Elektronikmodul 1 weist wie die in den Figuren 1 bis 3 gezeigten Ausführungsbeispiele neben dem elektrischen Bauelement 5 eine pulsierende Heatpipe 3 mit einer Kanalstruktur 7 und einem in der Kanalstruktur 7 angeordneten Wärmetransportmedium 9 zur Aufnahme und zum Abtransport von dem elektrischen Bauelement 5 erzeugter Wärme auf. Im Unterschied zu den in den Figuren 1 bis 3 gezeigten Ausführungsbeispielen ist das elektrische Bauelement 5 jedoch in der Kanalstruktur 7 der pulsierenden Heatpipe 3 angeordnet, so dass es von dem Wärmetransportmedium 9 umströmt wird. Ein weiterer Unterschied zu den in den Figuren 1 bis 3 gezeigten Ausführungsbeispielen ist, dass die Kanalstruktur 7 statt von einem elektrisch leitfähigen Deckelelement 17 von einer Leiterplatte 27 verschlossen wird. Die Leiterplatte 27 weist Leiterbahnen 29, 30, 31 auf, die mit dem elektrischen Bauelement 5 elektrisch verbunden sind. Das elektrische Bauelement 5 ist an einem elektrisch leitfähigen Träger 33 angeordnet, der durch Befestigungspins 35 mit dem Trägerelement 18 verbunden und beispielsweise aus Kupfer gefertigt ist. Das Trägerelement 18 ist aus einem Metall gefertigt.

Die in den Figuren gezeigten Ausführungsbeispiele eines erfindungsgemäßen Elektronikmoduls 1 können in verschiedener Weise zu weiteren Ausführungsbeispielen abgewandelt werden. Beispielsweise kann das Elektronikmodul 1 statt nur ein elektrisches Bauelement 5 jeweils mehrere elektrische Bauelemente 5 aufweisen, die jeweils wie in Figur 1 über ein elektrisch leitfähiges Deckelelement 17 oder wie in den Figuren 3 oder 4 direkt mit dem Wärmetransportmedium 9 in thermischem Kontakt stehen, wobei insbesondere auch eines oder mehrere der elektrischen Bauelemente 5 über ein Deckelelement 17 und eines oder mehrere der elektrischen Bauelemente 5 direkt mit dem Wärmetransportmedium 9 in thermischem Kontakt stehen können. Ferner kann die pulsierende Heatpipe 3 unterseitig statt durch ein Trägerelement 18 durch einen Keramikkörper 15, 16 verschlossen sein, der auch Wände der Kanalstruktur 7 bildet. Insbesondere kann die pulsierende Heatpipe 3 nur einen Keramikkörper 15, 16 aufweisen, der sowohl den Boden als auch die Wände der pulsierenden Heatpipe 3 bildet. Alternativ kann die pulsierende Heatpipe 3 mehr als nur zwei Keramikkörper 15, 16 aufweisen, insbesondere um eine geometrisch komplexe Kanalstruktur 7 zu realisieren. Des Weiteren können die in den Figuren 1 bis 3 gezeigten Ausführungsbeispiele dahingehend abgewandelt werden, dass die Kanalstruktur 7 oberseitig nur bereichsweise durch wenigstens ein elektrisch leitfähiges Deckelelement 17 verschlossen ist, während andere Bereiche der Kanalstruktur 7 jeweils durch ein elektrisch isolierendes Element verschlossen sind oder der oder die Keramikkörper 15, 16 in diesen Bereichen oberseitig geschlossen ausgeführt sind. Ferner kann die Kanalstruktur 7 anders als in Figur 2 ausgebildet sein. Beispielsweise kann die Kanalstruktur 7 mehrere Kanäle und/oder einen oder mehrere stern- oder rosettenartig verlaufende Kanäle aufweisen.

## Patentansprüche

1. Elektronikmodul (1), umfassend
- eine pulsierende Heatpipe (3) mit einer Kanalstruktur (7), in der ein Wärmetransportmedium (9) angeordnet ist, und
- wenigstens ein elektrisches Bauelement (5), das mit dem Wärmetransportmedium (9) direkt in Kontakt steht und/oder mit einem elektrisch leitfähigen Kontaktelement (17,33) verbunden ist, das mit dem Wärmetransportmedium (9) direkt in Kontakt steht,
**dadurch gekennzeichnet dass** die Kanalstruktur (7) aus Keramikkörpern (15, 16), einem metallischen Deckelelement (17) und einem metallischen Trägerelement (18) gebildet ist.

2. Elektronikmodul (1) nach Anspruch 1, wobei die pulsierende Heatpipe (3) plattenartig ausgebildet ist.

3. Elektronikmodul (1) nach Anspruch 1 oder 2, wobei die Kanalstruktur (7) wenigstens einen mäanderartig verlaufenden Kanal aufweist.

4. Elektronikmodul (1) nach einem der vorhergehenden Ansprüche, wobei die Kanalstruktur (7) planar ausgebildet ist.

5. Elektronikmodul (1) nach einem der vorhergehenden Ansprüche, wobei die pulsierende Heatpipe (3) wenigstens einen Keramikkörper (15,16) aufweist, der Wände der Kanalstruktur (7) bildet, die Kanalabschnitte der Kanalstruktur (7) voneinander trennen.

6. Elektronikmodul (1) nach einem der vorhergehenden Ansprüche, wobei die pulsierende Heatpipe (3) ein mit dem Wärmetransportmedium (9) in Kontakt stehendes elektrisch leitfähiges Deckelelement (17) aufweist, an dem wenigstens ein elektrisches Bauelement (5) angeordnet ist und das die Kanalstruktur (7) zumindest in einer Umgebung des elektrischen Bauelements (5) deckelartig verschließt.

7. Elektronikmodul (1) nach Anspruch 6, wobei das Deckelelement (17) im Bereich wenigstens eines an ihr angeordneten elektrischen Bauelements (5) wenigstens eine Aussparung (23,24) aufweist, durch die die Kanalstruktur (7) der pulsierenden Heatpipe (3) mit einer Oberfläche (25) des elektrischen Bauelements (5) verbunden ist, so dass das Wärmetransportmedium (9) direkt mit der Oberfläche (25) des elektrischen Bauelements (5) in Kontakt steht.

8. Elektronikmodul (1) nach Anspruch 6 oder 7, wobei das Deckelelement (17) aus einem Metall, insbesondere aus Kupfer, oder einer Legierung gefertigt ist.

9. Elektronikmodul (1) nach einem Ansprüche 6 bis 8, wobei die pulsierende Heatpipe (3) ein Trägerelement (18) aufweist, das die Kanalstruktur (7) auf einer dem Deckelelement (17) gegenüberliegenden Seite verschließt.

10. Elektronikmodul (1) nach Anspruch 9,
wobei das Trägerelement (18) aus Kupfer gefertigt ist.

11. Elektronikmodul (1) nach einem der vorhergehenden Ansprüche, wobei wenigstens ein elektrisches Bauelement (5) in der Kanalstruktur (7) der pulsierenden Heatpipe (3) angeordnet ist, so dass es von dem Wärmetransportmedium (9) umströmt wird.

12. Elektronikmodul (1) nach einem der vorhergehenden Ansprüche, wobei das Wärmetransportmedium (9) ein elektrisch nichtleitendes Fluid, insbesondere Perfluor-N-alkyl-morpholin, ist.

13. Elektronikmodul (1) nach einem der vorhergehenden Ansprüche, wobei wenigstens ein elektrisches Bauelement (5) ein Leistungshalbleiter ist.

14. Verfahren zur Herstellung eines gemäß einem der vorhergehenden Ansprüche ausgebildeten Elektronikmoduls (1), wobei die pulsierende Heatpipe (3) nach dem Montieren aller elektrischen Bauelemente (5) durch wenigstens eine Befüllungsöffnung (19) mit dem Wärmetransportmedium (9) befüllt wird und jede Befüllungsöffnung (19) nach dem Befüllen verschlossen wird.

15. Verfahren nach Anspruch 14, wobei die pulsierende Heatpipe (3) wenigstens teilweise durch 3D-Druck hergestellt wird.

## Claims

1. Electronic module (1), comprising
- a pulsating heat pipe (3) with a channel structure (7), in which a heat transport medium (9) is arranged, and
- at least one electrical structural element (5), which is in direct contact with the heat transport medium (9) and/or is connected to an electrically conductive contact element (17,33) that is in direct contact with the heat transport medium (9),
**characterised in that** the channel structure (7) is formed of ceramic bodies (15, 16), a metallic cover element (17) and a metallic carrier element (18).

2. Electronic module (1) according to claim 1, wherein the pulsating heat pipe (3) is embodied in a plate-like manner.

3. Electronic module (1) according to claim 1 or 2, wherein the channel structure (7) has at least one channel running in a meandering manner.

4. Electronic module (1) according to one of the preceding claims, wherein the channel structure (7) is embodied in a planar manner.

5. Electronic module (1) according to one of the preceding claims, wherein the pulsating heat pipe (3) has at least one ceramic body (15,16), which forms walls of the channel structure (7) that separate the channel sections of the channel structure (7) from one another.

6. Electronic module (1) according to one of the preceding claims, wherein the pulsating heat pipe (3) has an electrically conductive cover element (17), which is in contact with the heat transport medium (9) and on which at least one electrical structural element (5) is arranged and which, at least in a surrounding area of the electrical structural element (5), closes off the channel structure (7) in the manner of a cover.

7. Electronic module (1) according to claim 6, wherein the cover element (17) has, in the region of at least one electrical structural element (5) arranged on it, at least one recess (23,24), through which the channel structure (7) of the pulsating heat pipe (3)is connected to a surface (25) of the electrical structural element (5), meaning that the heat transport medium (9) is in direct contact with the surface (25) of the electrical structural element (5).

8. Electronic module (1) according to claim 6 or 7, wherein the cover element (17) is made of a metal, in particular copper, or an alloy.

9. Electronic module (1) according to one of claims 6 to 8, wherein the pulsating heat pipe (3) has a carrier element (18), which closes off the channel structure (7) on a side opposite the cover element (17).

10. Electronic module (1) according to claim 9,
wherein the carrier element (18) is made of copper.

11. Electronic module (1) according to one of the preceding claims, wherein at least one electrical structural element (5) is arranged in the channel structure (7) of the pulsating heat pipe (3), meaning that the heat transport medium (9) is able to flow around it.

12. Electronic module (1) according to one of the preceding claims, wherein the heat transport medium (9) is an electrically non-conductive fluid, in particular perfluoro-N-alkyl-morpholine.

13. Electronic module (1) according to one of the preceding claims, wherein at least one electrical structural element (5) is a power semiconductor.

14. Method for producing an electronic module (1) embodied according to one of the preceding claims, wherein the pulsating heat pipe (3) is filled with the heat transport medium (9) through at least one filling opening (19) once all electrical structural elements (5) have been installed, and each filling opening (19) is closed off after the filling.

15. Method according to claim 14, wherein the pulsating heat pipe (3) is at least partially produced by 3D printing.

## Revendications

1. Module (1) électronique, comprenant
- un caloduc (3) pulsatoire ayant une structure (7) à canal, dans lequel est disposé un milieu (9) de transport de la chaleur, et
- au moins un composant (5) électrique, qui est en contact directement avec le milieu (9) de transport de la chaleur et/ou est connecté à un élément (17, 33) de contact conducteur de l'électricité, qui est en contact directement avec le milieu (9) de transport de la chaleur,
**caractérisé en ce que**
la structure (7) à canal est formée de pièces (15, 16) de céramique, d'un élément (17) métallique de recouvrement et d'un élément (18) métallique de support.

2. Module (1) électronique suivant la revendication 1, dans lequel le caloduc (3) pulsatoire est de type en plaque.

3. Module (1) électronique suivant la revendication 1 ou 2, dans lequel la structure (7) à canal a au moins un canal s'étendant sinueusement.

4. Module (1) électronique suivant l'une des revendications précédentes, dans lequel la structure (7) à canal est plane.

5. Module (1) électronique suivant l'une des revendications précédentes, dans lequel le caloduc (3) pulsatoire a au moins une pièce (15, 16) en céramique, qui forme des parois de la structure (7) à canal, lesquelles séparent l'un de l'autre des tronçons de la structure (7) à canal.

6. Module (1) électronique suivant l'une des revendications précédentes, dans lequel le caloduc (3) pulsatoire a un élément (17) formant couvercle de recouvrement conducteur de l'électricité en contact avec le milieu (9) de transport de la chaleur, sur lequel est monté au moins un composant (5) électrique et qui ferme à la manière d'un couvercle la structure (7) à canal au moins alentour du composant (5) électrique.

7. Module (1) électronique suivant la revendication 6, dans lequel l'élément (17) formant couvercle a, dans la partie d'au moins un composant (5) électrique monté sur lui, au moins un évidement (23, 24), qui met la structure (7) à canal du caloduc (3) pulsatoire en communication avec une surface (25) du composant (3) électrique, de manière à ce que le milieu (9) de transport de la chaleur soit en contact directement avec la surface (25) du composant (5) électrique.

8. Module (1) électronique suivant la revendication 6 ou 7, dans lequel l'élément (17) formant couvercle est en un métal, en particulier en cuivre ou en un alliage.

9. Module (1) électronique suivant l'une des revendications 6 à 8, dans lequel le caloduc (3) pulsatoire a un élément (18) formant support, qui ferme la structure (7) à canal du côté opposé à l'élément (17) formant couvercle.

10. Module (1) électronique suivant la revendication 9, dans lequel l'élément (18) formant support est en cuivre.

11. Module (1) électronique suivant l'une des revendications précédentes, dans lequel au moins un composant (5) électrique est disposé dans la structure (7) à canal du caloduc (3) pulsatoire, de manière à ce que le milieu (9) de transport de la chaleur passe autour de lui.

12. Module (1) électronique suivant l'une des revendications précédentes, dans lequel le milieu (9) de transport de la chaleur est un fluide non conducteur de l'électricité, en particulier une perfluoro-N-alcoyl-morpholine.

13. Module (1) électronique suivant l'une des revendications précédentes, dans lequel au moins un composant (5) électrique est un semiconducteur de puissance.

14. Procédé de fabrication d'un module (1) électronique constitué suivant l'une des revendications précédentes, dans lequel on remplit du milieu (9) de transport de la chaleur, par au moins une ouverture (19) de remplissage, le caloduc (3) pulsatoire après le montage de tous les composants (5) électriques et on ferme après le remplissage chaque ouverture (19) de remplissage.

15. Procédé suivant la revendication 14, dans lequel on fabrique le caloduc (3) pulsatoire au moins en partie par impression en 3D.
